# EUROPÄISCHE PATENTSCHRIFT

(11) **EP 1 151 316 B1**
(45) Veröffentlichungstag und Bekanntmachung des Hinweises auf die Patenterteilung: **21.09.2005**
(21) Anmeldenummer: 99973690.3
(22) Anmeldetag: 13.11.1999
(51) Int. Cl.: G01R 33/60

(54) **VERFAHREN UND VORRICHTUNG ZUM UNTERSUCHEN DER HALTBARKEIT VON FLÜSSIGEN NAHRUNGSMITTELN MITTELS ELEKTRONENSPINRESONANZ**
METHOD AND DEVICE FOR ANALYSING THE STABILITY OF FLUID FOODSTUFFS BY MEANS OF ELECTRON SPIN RESONANCE
PROCEDE ET DISPOSITIF D'ANALYSE DE DURABILITE DE PRODUITS ALIMENTAIRES LIQUIDES PAR RESONANCE DE SPIN ELECTRONIQUE

(43) Veröffentlichungstag der Anmeldung: 07.11.2001
(73) Patentinhaber: Bruker BioSpin GmbH, 76287 Rheinstetten (DE)
(72) Erfinder: SCHMALBEIN, Dieter, 76359 Burbach (DE); JIANG, JinJie, 01821 Billerica, MA 01821 (US); HEISS, Arthur H., 06804 Brookfield, CT 06804 (US); WEBER, Ralph T., 02472 Watertown, MA 02472 (US); KAMLOWSKI, Andreas, 76768 Berg (DE)
(74) Vertreter: Witte, Alexander
(86) Internationale Anmeldenummer: PCT/EP1999/008761
(87) Internationale Veröffentlichungsnummer: WO 2001/036994

(56) Entgegenhaltungen:
- EP-A- 0 720 026
- WO-A-97/16750

## Beschreibung

Die Erfindung betrifft ein Verfahren zum Untersuchen der Haltbarkeit von flüssigen Nahrungsmitteln mittels Elektronenspinresonanz (ESR), bei dem eine Probe des Nahrungsmittels über einen längeren Zeitraum einer gegenüber Raumtemperatur erhöhten Temperatur ausgesetzt wird, wobei während des Zeitraumes in vorbestimmten zeitlichen Abständen ein ESR-Signal der Probe gemessen, die Intensität des ESR-Signals über der Zeit aufgetragen und der Zeitpunkt eines überproportionalen Anstieges der Intensität erfaßt wird.

Die Erfindung betrifft weiterhin ein Vorrichtung zum Untersuchen der Haltbarkeit von flüssigen Nahrungsmitteln mittels Elektronenspinresonanz (ESR), wobei eine Probe des Nahrungsmittels über einen längeren Zeitraum einer gegenüber Raumtemperatur erhöhten Temperatur ausgesetzt und während des Zeitraumes in vorbestimmten zeitlichen Abständen ein ESR-Signal der Probe gemessen, die Intensität des ESR-Signals über der Zeit aufgetragen und der Zeitpunkt eines überproportionalen Anstieges der Intensität erfaßt wird.

Die Proben werden dabei mit einer sogenannten Spin-Trap-Substanz oder einer Spin-Label-Substanz versehen oder es ist bereits eine entsprechende intrinsische Substanz in der Probe vorhanden.

Ein Verfahren der vorstehend genannten Art ist aus einem Aufsatz von Kaneda, H. et al. "Free Radical Reactions in Beer during Pasteurization", International Journal of Food Science and Technology (1994), 29, Seite 195 bis 200 bekannt. Ein entsprechendes Verfahren sowie eine Vorrichtung zu dessen Durchführung ist auch in der EP 0 720 026 A2 beschrieben. Eine weitere Beschreibung eines derartigen Verfahrens mit zugehörigen Vorrichtung findet sich in einer Anwenderschrift von Barr, D. "Measuring Flavor Stability of Beer using the Bruker EMX Spectrometer", Bruker EPR Application Note (1998).

Zum Verständnis des vorliegenden Verfahrens sei zunächst kurz auf die zugrunde liegende Meßtechnik der Elektronenspinresonanz eingegangen.

Die Elektronenspinresonanz (ESR) ist ein Teilgebiet der magnetischen Resonanz. Bei der ESR wird eine Probensubstanz gleichzeitig einem hochfrequenten elektromagnetischen Feld sowie einem starken Konstantmagnetfeld hoher Homogenität ausgesetzt. Durch Verändern der Feldstärke des Konstantmagnetfeldes werden unterschiedliche Elektronenspinresonanzen in der Probe angeregt und können als Spektrum aufgezeichnet werden. Typischerweise wird in der ESR ein hochfrequentes elektromagnetisches Feld im X-Band, d.h. bei etwa 10 GHz, eingesetzt, wobei dann die Stärke des Konstantmagnetfeldes bei etwa 0,32 T liegt. Es ist aber auch bekannt, ESR-Messungen einerseits bei mehr als zehnmal so hohen Frequenzen und andererseits auch nur bei einem Zehntel dieser Frequenz durchzuführen.

Zur Anregung der ESR ist es, wie erwähnt, lediglich erforderlich, die Probensubstanz dem magnetischen Hochfrequenzfeld auszusetzen. Bei Meßfrequenzen im Mikrowellenbereich werden zu diesem Zweck üblicherweise Hohlraumresonatoren eingesetzt. Dies ist meistens ein Rechteck-Resonator vom Schwingungstyp TE₁₀ₙ, gelegentlich werden aber auch zylindrische Resonatoren vom Schwingungstyp TE₀₁₁ verwendet.

Die Rechteckresonatoren werden üblicherweise in doppelter Länge, d.h. als TE₁₀₂-Resonatoren aufgebaut, wobei dann ein Probengefäß in Form eines Probenröhrchens in der Resonatormitte eingesetzt werden kann, wo die H-Linien beider Resonanzschleifen zueinander parallel verlaufen. Die Probe befindet sich damit am Ort der maximalen magnetischen Hochfrequenzfeldstärke. Aufgrund der Verhältnisse bei diesem Schwingungstyp ist dies zugleich der Ort minimaler elektrischer Hochfrequenzfeldstärke. Dies ist bei verlustbehafteten Proben von Vorteil, weil auf diese Weise die dielektrischen Verluste minimal sind.

Wenn bei ESR-Messungen flüssige Proben untersucht werden sollen, die von Hause aus mit starken dielektrischen Verlusten behaftet sind, so muß man darauf achten, daß die flüssige Probensubstanz sich in größtmöglichem Maße in der Ebene befindet, in der die magnetische Hochfrequenzfeldstärke maximal und die elektrische Hochfrequenzfeldstärke minimal ist. Um dies zu erreichen, kann man entweder eine einzelne dünne Kapillare verwenden, es ist aber auch bekannt, sogenannte "Flachzellen" einzusetzen, d.h. Probenröhrchen, die im Meßbereich flachgedrückt sind. Auf diese Weise wird die flüssige Probensubstanz näherungsweise in einer Ebene verteilt, so daß man verhältnismäßig viel Probensubstanz in der erwähnte Ebene maximaler magnetischer und minimaler elektrischer Hochfrequenzfeldstärke unterbringen kann.

Probenköpfe der vorstehend genannten Art sind allgemein bekannt und von den einschlägigen Herstellern kommerziell erhältlich.

Es ist darüber hinaus in der magnetischen Resonanz bekannt, zum Durchführen von Vergleichsmessungen mehrere unterschiedliche Proben in voneinander getrennten Gefäßen oder zumindest an voneinander getrennten Orten in demselben Probenkopf unterzubringen. Auf diese Weise kann man entweder unmittelbare Vergleichsmessungen zwischen zwei Probensubstanzen durchführen, oder man kann eine der beiden Substanzen, die eine Referenzsubstanz ist, als Standard verwenden, während nur die andere Substanz untersucht wird. Dieser Standard kann zu quantitativen Eichzwecken verwendet werden oder aber auch um eine Feldregelung (sogenannter "interner Lock") durchzuführen. In diesem Zusammenhang sind mehrere Probenköpfe bekannt geworden, die es gestatten, gleichzeitig zwei unterschiedliche Probensubstanzen in einem Probenraum, bzw. zwei voneinander unabhängigen Probenräumen, unterzubringen.

Ein Beispiel eines derartigen bekannten Probenkopfes ist im Aufsatz von DALAL et al. "The effects of lossy solvents on quantitative EPR studies", Journal of Magnetic Resonance, 44, pp. 415-428 (1981) beschrieben.

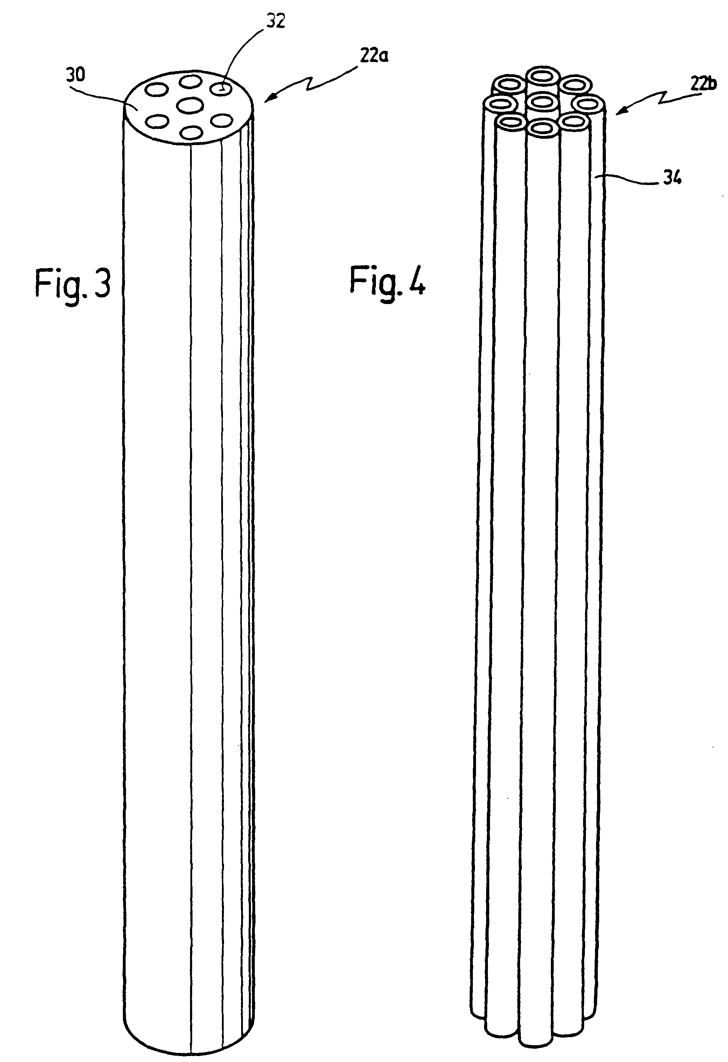

Bei diesem bekannten Probenkopf (Fig. 3 in dem erwähnten Aufsatz) wird eine Probenröhrchenanordnung verwendet, bei der in einem dünnwandigen NMR-Probenröhrchen von 0,5 cm Außendurchmesser eine erste Kapillare mit einem Innenradius von 0,05 cm und wahlweise ein Quarzröhrchen mit einem Radius von 0,064 cm oder ebenfalls eine Kapillare mit Innenradius 0,05 cm verwendet wird. Die erste Kapillare enthält die Probensubstanz, die in einem nicht-verlustbehafteten Lösungsmittel als Referenzsubstanz aufgelöst ist, während die zweite Kapillare bzw. das Röhrchen das an sich üblicherweise verwendete, verlustbehaftete Lösungsmittel enthält. Die beiden Röhrchen sind in der Ebene minimaler elektrischer Hochfrequenzfeldstärke angeordnet.

Aus der US 5 552 709 ist ein Probenkopf für Kernresonanzmessungen (NMR) bekannt. Der bekannte Probenkopf ist von lang gestreckter Gestalt und enthält eine Vielzahl parallel angeordneter Kapillaren. Die Wände der Kapillaren bestehen aus nicht leitenden Material, so daß der Gütefaktor Q des Resonanzsystems vergrößert werden soll, indem die elektrischen Verluste reduziert werden, die durch radial zur Probengefäßachse fließende Ströme verursacht werden.

Bei einem weiteren Probengefäß NMR-Spektrometer, wie es in der US 5 469 061 A beschrieben ist, werden ebenfalls mehrere nebeneinander angeordnete Kapillaren als Probengefäß verwendet. Diese Kapillaren sind in Reihe geschaltet, so daß eine Durchflußzelle entsteht, bei der die flüssige Probensubstanz durch eine Kapillare einströmt, dann unter Wechsel der Flußrichtung nacheinander durch sämtliche weiteren Kapillaren fließt und schließlich durch eine weitere Kapillare abströmt.

Aus der US 5 596 276 A ist schließlich noch ein Standard-Rechteck-Resonator bekannt, wie er in Elektronenspinresonanz-Spektrometern verwendet wird.

Die bekannten Probenköpfe dienen daher ausschließlich zu Vergleichsmessungen zwischen zwei Proben, von denen üblicherweise eine zu Referenzzwecken bekannt ist.

Während ESR-Messungen an flüssigen Proben in früherer Zeit eine eher untergeordnete Rolle spielten, weil die ESR als analytisches Instrument überwiegend bei Festkörpern eingesetzt wurde, sind in jüngerer Zeit verschiedene Anwendungsfälle in den Vordergrund gerückt, bei denen ESR an flüssigen Proben eingesetzt wird.

Einer dieser Anwendungsfälle ist die Untersuchung der Haltbarkeit von Bier. Man hat festgestellt, daß die Alterung von Bier, insbesondere das "Umkippen" von Bier in einen nicht mehr verbrauchsfähigen Zustand, auf die Entstehung verschiedener Aldehyde zurückzuführen ist, die Nebenprodukte von Reaktionen sind, an denen freie Radikale beteiligt sind. Es handelt sich hier um vergleichbare Prozesse, wie sie auch in anderen Lebensmitteln auftreten, bspw. bei Fleisch und Molkereiprodukten.

Das Verhalten der freien Radikale ist dabei stark temperaturabhängig, wobei die Prozesse um so langsamer ablaufen, je niedriger die Lagertemperatur, z.B. des Biers, ist. Es ist bekannt, daß im Bier natürlich vorkommende Antioxidantien enthalten sind, die den Prozessen der erwähnten freien Radikale entgegenwirken. Mittels ESR kann nun das Verhalten der freien Radikale untersucht werden, indem man das sogenannte "spin-trapping"-oder "spin-labelling"-Verfahren einsetzt. Bei diesem Verfahren wird eine Bierprobe zunächst entgast, und es wird ihr dann eine "spin-trapping"- bzw. "spin-labelling"-Substanz hinzugefügt. Die auf diese Weise präparierte Bierprobe wird dann einem thermischen Stressprogramm unterworfen, indem man sie auf höhere Temperatur, bspw. 60°C, bringt, um auf diese Weise den Alterungsprozeß in zeitlicher Raffung nachzubilden. Durch periodische ESR-Messung, bspw. alle zehn Minuten, kann nun der Alterungsprozeß des Bieres überwacht werden. Es ist auf diese Weise in relativ kurzer Zeit möglich, einen Indikator dafür zu finden, ob das untersuchte Bier voraussichtlich lange halten wird oder nicht. Dies wiederum gestattet es, auf den Brauprozeß Einfluß zu nehmen, um durch wiederholte Messungen der vorstehend beschriebenen Art schlußendlich die Haltbarkeit des Bieres zu verlängern. Bei anderen Probenmaterialien sind entsprechende Substanzen bereits intrinsisch vorhanden.

Das vorstehend genannte Verfahren ist in den eingangs genannten Aufsätzen von Hirotaka und Barr sowie in der EP 0 720 026 A2 in weiteren Einzelheiten beschrieben, so daß insoweit darauf verwiesen werden darf.

Um ESR-Messungen an flüssigen Proben z.B. in dem beschriebenen Anwendungsfall (Untersuchung der Haltbarkeit von Nahrungsmitteln, oder fermentierten Flüssigkeiten, speziell Bier oder auch z.B. Wein oder Molkereiprodukten) einzusetzen, ist es erforderlich, mit relativ großen Probenmengen zu arbeiten, um möglichst schnell möglichst ausreichend große Signale zu erzielen. Darüber hinaus soll ein entsprechendes Verfahren in möglichst großem Umfange automatisierbar sein.

Mit den bekannten Probenköpfen für ESR-Spektrometer, die eine Messung an flüssigen Proben gestatten, ist dies nicht ohne weiteres möglich, weil es sich hierbei in der Regel um Apparaturen für den Einsatz in wissenschaftlichen Laboratorien handelt, deren Handhabung diffizil ist und daher ein hohes Ausmaß an Fertigkeiten und vor allem auch einen hohen Zeitaufwand erfordert.

Ein wesentlicher Nachteil des bekannten Verfahrens und der genannten Vorrichtung, wie sie in den eingangs genannten drei Druckschriften beschrieben sind, liegt darin, daß ein erheblicher Zeitaufwand für die Durchführung der Messungen erforderlich ist. Während dieser Zeitaufwand für die Messung einer einzigen Biersorte (um bei diesem Beispiel zu bleiben) noch erträglich sein mag, wird der Zeitaufwand nicht mehr hinnehmbar, wenn eine Mehrzahl von Proben verschiedener Nahrungsmittel (Biere) zur Messung anstehen. Dies kann z.B. in einer Großbrauerei der Fall sein, wo die in unterschiedlichen Kesseln gebrauten Bierchargen gleicher oder unterschiedlicher Biersorte während des Gärvorganges laufend überwacht werden sollen, um notfalls in den Gärvorgang derart einzugreifen, daß die prognostizierte Haltbarkeit des Bieres verbessert wird.

Bei Anwendung der bekannten Verfahren und Vorrichtungen würde man z.B. für die Messung von sechs verschiedenen Proben unterschiedlicher Nahrungsmittel (Biere) die sechsfache Zeit einer einfachen Messung benötigen. Da aber bereits eine einfache Messung in der Größenordnung von einer Stunde erfordert, würde ein Meßergebnis erst nach vielen Stunden zur Verfügung stehen. Dann ist es für Eingriffe in den Herstellungsprozeß (Gärprozeß) des Nahrungsmittels möglicherweise bereits zu spät.

Nun könnte man zwar in derartigen Fällen die Anzahl der Meßvorrichtungen entsprechend vervielfachen. Dies scheidet jedoch an wirtschaftlichen Überlegungen, weil ESR-Spektrometer sehr aufwendige und damit auch sehr teure Meßgeräte sind.

Der Erfindung liegt daher die Aufgabe zugrunde, ein Verfahren und eine Vorrichtung der eingangs genannten Art dahingehend weiterzubilden, daß eine simultane Messung an mehreren Proben möglich ist, so daß verschiedene Nahrungsmittel (Biere) nahezu zeitparallel gemessen werden können, ohne daß dafür weitere Meßvorrichtungen angeschafft werden müssen.

Bei einem Verfahren der eingangs genannten Art wird diese Aufgabe erfindungsgemäß dadurch gelöst, daß auf automatisierte Art und zeitlich ineinander verschachtelt mittels eines Steuergeräts eine vorbestimmte Anzahl n von Proben unterschiedlicher Nahrungsmittel gleichzeitig untersucht wird, indem in einem für die Proben gemeinsamen Probengefäß die folgenden Schritte automatisiert ausgeführt werden:
a) Einfüllen einer ersten Probe eines ersten Nahrungsmittels in das Probengefäß;
b) Untersuchen der ersten Probe mittels ESR und Erfassen der Intensität des ESR-Signals;
c) Eintragen der in Schritt b) erfaßten Intensität als erster Meßpunkt in ein erstes Diagramm;
d) Ablassen der ersten Probe;
e) n-1-maliges Wiederholen der Schritte a) bis d) mit den n-1 Proben der anderen Nahrungsmittel, wobei in Schritt c) die erfaßten Intensitäten für jedes Nahrungsmittel als erste Punkte in ein separates Diagramm eingetragen werden, und die Zahl n so bemessen ist, daß die n-malige Ausführung der Schritte a) bis d) im wesentlichen mit dem vorbestimmten zeitlichen Abstand übereinstimmt;
f) Einfüllen einer weiteren ersten Probe des ersten Nahrungsmittels in das Probengefäß;
g) Untersuchen der weiteren ersten Probe mittels ESR und Erfassen der Intensität des ESR-Signals;
h) Eintragen der in Schritt g) erfaßten Intensität als zweiter Meßpunkt in das erste Diagramm;
i) Ablassen der weiteren ersten Probe;
j) n-1-maliges Wiederholen der Schritte e) bis i) mit den n-1 Proben der anderen Nahrungsmittel, wobei in Schritt h) die erfaßten Intensitäten für jedes Nahrungsmittel als zweite Punkte in die separaten Diagramme eingetragen werden; und
k) Wiederholen der Schritte e) bis j) für dritte und weitere Meßpunkte, bis eine vorbestimmte Anzahl m an Meßpunkten je Diagramm erreicht ist.

Bei einer Vorrichtung der eingangs genannten Art wird die Erfindung zugrunde liegende Aufgabe dadurch gelöst, daß zum gleichzeitigen, automatisierten Untersuchen einer vorbestimmten Anzahl n von Proben unterschiedlicher Nahrungsmittel mittels eines Steuergeräts ein für die Proben gemeinsames Probengefäß vorgesehen ist und die Vorrichtung umfaßt:
a) Mittel zum Einfüllen einer ersten Probe eines ersten Nahrungsmittels in das Probengefäß;
b) Mittel zum Untersuchen der ersten Probe mittels ESR und Erfassen der Intensität des ESR-Signals;
c) Mittel zum Eintragen der in Schritt b) erfaßten Intensität als erster Meßpunkt in ein erstes Diagramm;
d) Mittel zum Ablassen der ersten Probe;
e) Mittel zum n-1-maligen Wiederholen der Schritte a) bis d) mit den n-1 Proben der anderen Nahrungsmittel, wobei in Schritt c) die erfaßten Intensitäten für jedes Nahrungsmittel als erste Punkte in ein separates Diagramm eingetragen werden, und die Zahl n so bemessen ist, daß die n-malige Ausführung der Schritte a) bis d) im wesentlichen mit dem vorbestimmten zeitlichen Abstand übereinstimmt;
f) Mittel zum Einfüllen einer weiteren ersten Probe des ersten Nahrungsmittels in das Probengefäß;
g) Mittel zum Untersuchen der weiteren ersten Probe mittels ESR und Erfassen der Intensität des ESR-Signals;
h) Mittel zum Eintragen der in Schritt g) erfaßten Intensität als zweiter Meßpunkt in das erste Diagramm;
i) Mittel zum Ablassen der weiteren ersten Probe;
j) Mittel zum n-1-maligen Wiederholen der Schritte e) bis i) mit den n-1 Proben der anderen Nahrungsmittel, wobei in Schritt h) die erfaßten Intensitäten für jedes Nahrungsmittel als zweite Punkte in die separaten Diagramme eingetragen werden; und
k) Mittel zum Wiederholen der Schritte e) bis j) für dritte und weitere Meßpunkte, bis eine vorbestimmte Anzahl m an Meßpunkten je Diagramm erreicht ist.

Es wurde bereits erwähnt, daß die Probe vorab mit einer Spin-Trap- oder Spin-Label-Substanz versehen wurde oder eine Probe mit einer solchen intrinsisch vorhandenen Substanz verwendet wird.

Die der Erfindung zugrunde liegende Aufgabe wird auf diese Weise vollkommen gelöst.

Beim Durchführen des erfindungsgemäßen Verfahrens bzw. bei der Verwendung der erfindungsgemäßen Vorrichtung ergibt sich nämlich ein erheblicher Zeitgewinn gegenüber herkömmlichen Messungen. Die Messungen an den Einzelproben der unterschiedlichen Nahrungsmittel werden nämlich mit geringst möglichem zeitlichem Versatz ineinander verschachtelt, so daß die Gesamt-Meßzeit nur geringfügig länger ist als die herkömmliche Meßzeit einer einzigen Probe. Erfindungsgemäß wird nämlich durch einen Kunstgriff die Pause ausgenutzt, die bei herkömmlichen Messungen zwischen zwei Einzelmessungen an der Probe liegt.

Damit ist es bei nur geringem apparativem Mehraufwand möglich, mit einem einzigen ESR-Spektrometer eine Vielzahl von Proben unterschiedlicher Nahrungsmittel praktisch zeitparallel zu messen.

Bei einer ersten Alternative der Erfindung werden die Proben nach dem Ablassen rezirkuliert, so daß mit anderen Worten immer dieselben Proben in bestimmten zeitlichen Abständen durchgemessen werden.

Es ist jedoch andererseits auch möglich, die Proben nach dem Ablassen zu entsorgen, so daß die Proben eines bestimmten Nahrungsmittels als unterschiedliche Proben aus einem Vorrat des bestimmten Nahrungsmittels entnommen werden.

Während im erst genannten Fall ein etwas erhöhter apparativer Aufwand erforderlich ist, wird andererseits nur eine sehr geringe Probenmenge genötigt, weil dieselbe Probe immer wieder durchgemessen wird. Dies ist deswegen möglich, weil die Elektronenspinresonanz eine zerstörungsfreie Meßtechnik ist.

Bei der zweit genannten Alternative ist der apparative Aufwand geringer, allerdings muß ein etwas größeres Probenvolumen vorgehalten werden, nämlich ein Probenvolumen, das um einen Faktor größer ist, der der Anzahl der geplanten Meßpunkte entspricht.

Bei weiteren Ausgestaltungen der Erfindung wird bevorzugt das Probengefäß nach jeder Einzelmessung gespült.

Diese Maßnahme hat den Vorteil, daß Meßwertverfälschungen vermieden werden, die möglicherweise dadurch eintreten können, daß nach dem Ablassen einer einzelnen Probe noch Reste dieser Probe im Probengefäß verblieben sind.

Im Rahmen der vorliegenden Erfindung ist besonders bevorzugt, wenn die Proben in einem Resonator gemessen werden, in dem ein elektromagnetisches Feld ausbreitungsfähig ist, wobei das Probengefäß langgestreckt und im Resonator in Richtung der magnetischen Hochfrequenzfeldstärke, und zwar an einem Ort maximaler magnetischer und minimaler elektrischer Hochfrequenzfeldstärke angeordnet ist, wobei weiterhin die im Probengefäß enthaltene Probe des Nahrungsmittels in einer Richtung zunehmender elektrischer Hochfrequenzfeldstärke minimaler Abmessungen aufweist und die Proben in einem Probengefäß gemessen werden, das mit einer Vielzahl langgestreckter Probenräume mit minimalen radialen Abmessungen versehen ist.

Diese Maßnahme hat den Vorteil, daß die Messungen mit minimalen dielektrischen Verlusten durchgeführt werden können, was einer sehr hohen Güte des Meßkreises entspricht. Dies ist bei den sehr schmalbandigen Meßkreisen (Resonatoren) der Elektronenspinresonanz-Spektroskopie besonders wichtig, weil bereits geringfügige dielektrische Verluste zu einer dramatischen Abnahme des Gütefaktors Q führen. Dies unterscheidet die Elektronenspinresonanz grundsätzlich von der Kernresonanz, bei der Resonatoren in Spulenform verwendet werden, bei denen der Gütefaktor wesentlich niedriger ist und die elektrische Verluste den Gütefaktor wesentlich weniger beeinflussen.

Bei weiteren Ausgestaltungen der Erfindung können die Probenräume parallel angeordnet sein, wobei die Probe an einem Ende der Probenräume eingefüllt und an einem gegenüber liegenden Ende der Probenräume abgelassen wird.

Alternativ können die Probenräume in Reihe angeordnet sein, wobei die Probe an dem offenen Ende des ersten Probenraums in der Reihe eingefüllt und an dem offenen Ende des letzten Probenraumes in der Reihe abgelassen wird.

Beide Varianten haben den Vorteil, daß eine Durchflußzelle entspricht, die für die ESR-Messung an flüssigen Proben besonders geeignet ist, da infolge der dünnen Kapillaren nur sehr geringe dielektrische Verlust auftreten.

Insoweit gilt allgemein die überraschende Feststellung, daß die elektromagnetischen Verluste, die von einer flüssigen Probe in einem ESR-Probenkopf hervorgerufen werden, durchaus nicht nur von der Probenmenge und von der Positionierung der Probensubstanz im Resonator abhängen. Es hat sich vielmehr gezeigt, daß der schädliche Einfluß dieser Verluste deutlich dadurch vermindert werden kann, daß man die gewünschte gesamte Probenmenge auf eine Vielzahl von Einzelprobenmengen aufteilt und diese jeweils in langgestreckten Probenräumen im Resonator unterbringt. Wegen der besonderen Feldverteilung im Resonator, der sich einstellenden Spineffekte sowie der nur äußerst geringen radialen Leitungswege innerhalb der flüssigen Probensubstanz werden die Verluste erheblich vermindert.

Die hierbei wirksamen elektromagnetischen Verluste umfassen nicht nur die bekannten dielektrischen Verluste. Man muß zusätzlich berücksichtigen, daß durch die magnetische Komponente des elektromagnetischen Hochfrequenzfeldes auch Wirbelströme erzeugt werden. Diese sollten jedoch nach Möglichkeit vermieden bzw. minimiert werden. Das magnetische Hochfrequenzfeld führt nämlich bei einer leitfähigen Flüssigkeit zu Abschirmströmen um die Feldrichtung herum, und zwar im wesentlichen an der entsprechenden Probenoberfläche. Durch die Abschirmströme wird somit das an sich erwünschte Eindringen des Magnetfeldes in das Probeninnere behindert, was zu einer Signalabnahme führt. Wenn nun die Probe segmentiert wird, z.B. in Gestalt einer Aufteilung in Filamente, so führt das zu einer Unterbrechung der Wirbelströme. Dies wiederum hat ein erhöhtes Eindringen des Magnetfeldes in das Probeninnere und damit eine Signalerhöhung zur Folge.

Folglich wird erfindungsgemäß die Güte des Resonators weit weniger als seither beeinträchtigt, mit der schlußendlichen Folge, das bei einer relativ großen Menge an Probensubstanz ein entsprechend starkes Meßsignal zur Verfügung steht.

Dies eröffnet ganz neue Anwendungsmöglichkeiten innerhalb industrieller Fertigungsprozesse, weil es nicht mehr erforderlich ist, mit äußerster Präzision eine Probe zu präparieren, sondern vielmehr verhältnismäßig einfache Apparaturen und auch weniger geschultes Personal ausreichen, um quantitativ ausreichende Messungen durchzuführen.

Die Erfindung kann daher weiterhin bei einem Verfahren der eingangs genannten Art zum Untersuchen flüssiger Proben vorteilhaft eingesetzt werden, wenn ein Probenkopf der vorstehend genannten Art eingesetzt wird. Dies gilt, wie ebenfalls bereits erwähnt, vorzugsweise für Verwendungsfälle bei der Untersuchung der Haltbarkeit von flüssigen oder auch festen Nahrungsmitteln, insbesondere Getränken, vorzugsweise Bier.

Bei einer bevorzugten Ausgestaltung des erfindungsgemäßen Probenkopfes umfaßt das Probengefäß einen Block, der mit einer Vielzahl achsparalleler Bohrungen versehen ist.

Diese Maßnahme hat den Vorteil, daß ein insgesamt stabiles und reproduzierbares Probengefäß zur Verfügung steht, das in einfacher Weise gehandhabt und befüllt bzw. entleert werden kann.

Der Block ist dabei vorzugsweise im wesentlichen zylindrisch, kann aber bei anderen Ausgestaltungen der Erfindung auch im wesentlichen flach sein.

Alternativ kann man statt eines mit Bohrungen versehenen Blocks auch ein Bündel von Kapillaren als Probengefäß verwenden.

Diese Maßnahme hat den Vorteil, daß Kapillaren als fertige Elemente industriell erhältlich sind, so daß die erwähnten Bündel von Kapillaren in verhältnismäßig einfacher Weise und zu niedrigen Kosten hergestellt werden können.

Bei Probenköpfen der genannten Art ist besonders bevorzugt, wenn das Verhältnis der Summe der radialen Querschnittsflächen der Probenräume zur Gesamtquerschnittsfläche des Probengefäßes zwischen 0,2 und 0,6 liegt.

Dieses Verhältnis hat sich als optimal hinsichtlich der Maximierung des Probenvolumens einerseits und der Stabilität des Probengefäßes andererseits erwiesen.

Die Probenräume sind vorzugsweise im wesentlichen zylindrisch.

Diese Maßnahme hat den Vorteil, daß die Probengefäße verhältnismäßig einfach hergestellt werden können.

Wenn der Probenkopf bei einer üblichen ESR-Meßfrequenz im X-Band, bspw. bei 10 GHz, betrieben wird, liegt der Durchmesser der Probenräume zwischen 0,3 und 1,0 mm, vorzugsweise zwischen 0,5 und 0,8 mm.

In diesem Falle ist weiter bevorzugt, wenn bei einem im wesentlichen zylindrischen Probengefäß dessen Außendurchmesser zwischen 2,5 und 5 mm, vorzugsweise zwischen 2,8 und 3,8 mm, liegt.

Es versteht sich, daß diese Abmessungen sich auf das erwähnte Frequenzband beziehen, während bei niedrigeren Frequenzen (z.B.

S-Band) oder bei sehr viel höheren Frequenzen (Q-Band oder V-Band) die Abmessungen entsprechend größer bzw. kleiner gewählt werden.

Bei den erwähnten Anordnungen ist weiter bevorzugt, wenn die zylindrischen Probenräume im zylindrischen Probengefäß in der sogenannten hexagonal dichtesten Packung angeordnet sind, d.h. wenn entweder sieben oder neunzehn Probenräume um eine Mittelachse herum angeordnet sind.

Bei weiteren Ausführungen der Erfindung ist bevorzugt, wenn eine Pumpe an das Ablaßende der Probenräume angeschlossen ist.

Diese Maßnahme hat den Vorteil, daß das Befüllen und Entleeren der Probenräume im Probengefäß zuverlässig und schnell erfolgt.

Dies gilt insbesondere dann, wenn die Pumpe eine peristaltische Pumpe ist. Bei weiteren Ausführungsformen der Erfindung ist bevorzugt, wenn an das Einfüllende der Probenräume ein Ausgang eines Samplers angeschlossen ist und Eingänge des Samplers mit einer Mehrzahl von Behältern verbunden sind, die mit den unterschiedlichen Nahrungsmitteln befüllt sind.

Diese Maßnahme hat den Vorteil, daß die sequentielle Beschikkung der Probenräume des Probengefäßes mit den Proben der unterschiedlichen Nahrungsmittel in automatisierter und damit fernsteuerbarer Weise erfolgt.

Bei dieser Variante der Erfindung kann man schließlich vorsehen, daß ein weiterer Eingang des Samplers an einen mit Spülflüssigkeit befüllbaren Behälter angeschlossen ist.

Diese Maßnahme hat den Vorteil, daß nach jedem Meßvorgang, wie bereits weiter oben erwähnt, ein Spülvorgang zum Reinigen der Probenräume des Probengefäßes stattfinden kann.

Weitere Vorteile ergeben sich aus der Beschreibung und der beigefügten Zeichnung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine äußerst schematisierte Ansicht eines Ausführungsbeispiels eines erfindungsgemäßen Probenkopfes;
- Fig. 2: den Verlauf der elektrischen und der magnetischen Hochfrequenzfeldstärke entlang der Längsachse eines Rechteck-Resonators vom Schwingungstyp TE₁₀₂, wie er beim Probenkopf gemäß Fig. 1 verwendet wird;
- Fig. 3: in stark vergrößertem Maßstab ein Probengefäß, wie es beim Probenkopf gemäß Fig. 1 Verwendung finden kann;
- Fig. 4: eine Variante zur Darstellung gemäß Fig. 3;
- Fig. 5 bis 7: eine Draufsicht auf das Probengefäß gemäß Fig. 3 in drei unterschiedlichen Varianten;
- Fig. 8: eine weitere Darstellung, ähnlich den Fig. 5 bis 7, jedoch für eine weitere abgewandelte Ausführungsform;
- Fig. 9: ein Blockschaltbild eines Ausführungsbeispiels einer erfindungsgemäßen Vorrichtung;
- Fig. 10a bis 10g: Diagramme zur Erläuterung eines Ausführungsbeispiels des erfindungsgemäßen Verfahrens.

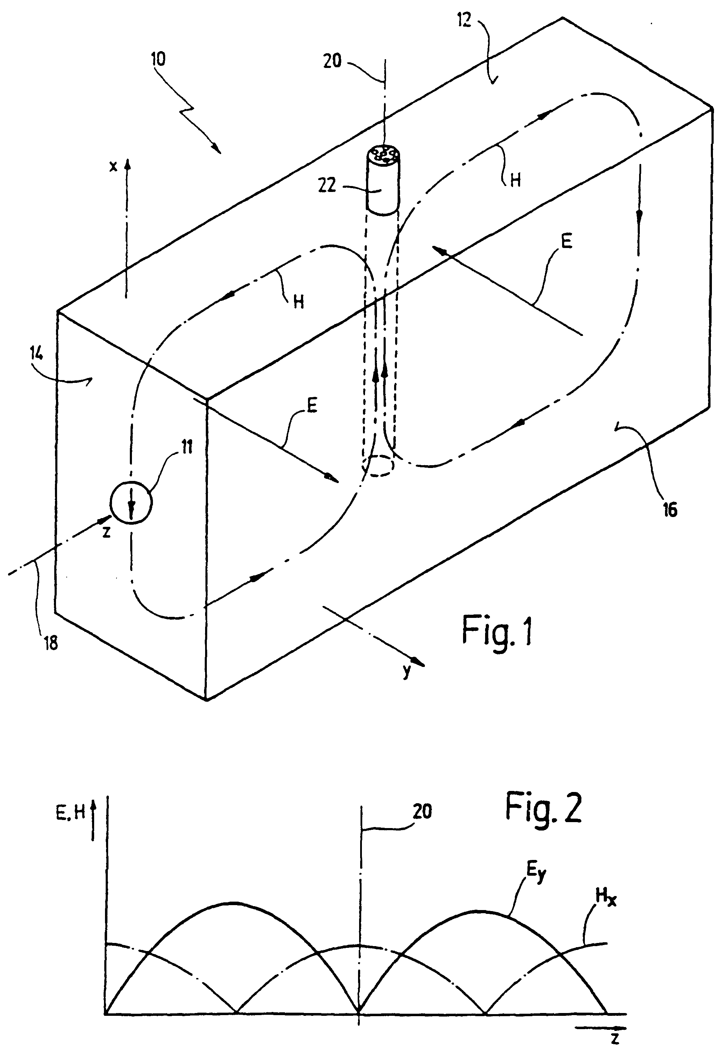

Fig. 1 zeigt einen Rechteck-Hohlraumresonator vom Schwingungstyp TE₁₀₂, wie er üblicherweise für ESR-Messungen verwendet wird. Der Resonator 10 wird über eine Koppeliris 11 an eine nicht dargestellte Mikrowellenleitung angekoppelt. Es breitet sich dann im Resonator 10 eine elektromagnetische Schwingung vom Typ TE₁₀ aus. Da die Länge des Resonators 10 entsprechend bemessen ist, entsteht ein Resonanz-Schwingungsmodus vom Typ TE₁₀₂. Die Feldlinien des magnetischen Hochfrequenzfeldes sind in Fig. 1 mit H, die des elektrischen Hochfrequenzfeldes mit E bezeichnet.

Der rechteckförmige Resonator 10 hat zwei Längsseiten 12, zwei Schmalseiten 14 sowie zwei Breitseiten 16. Die Längsachse ist mit 18 bezeichnet.

Wie man leicht erkennt, liegen die H-Feldlinien parallel zu den Breitseiten 16, während die E-Feldlinien dazu senkrecht verlaufen. Im Zentrum der Längsseite 12 liegt eine Probenachse 20, entlang der ein Probengefäß 22 in den Resonator 10 eingeführt werden kann.

Wie man aus dem Diagramm gemäß Fig. 2 erkennen kann, hat die in x-Richtung wirkende magnetische Hochfrequenzfeldstärke Hₓ im Bereich der Probenachse 20 ein Maximum, während die in y-Richtung wirkende elektrische Hochfrequenzfeldstärke E_{y} dort ein ausgeprägtes Minimum aufweist.

Für feste Meßproben ist dies nicht so wichtig, weil die dielektrischen Verluste in Festkörpern verhältnismäßig klein sind. Bei verlustbehafteten flüssigen Meßproben hingegen sind die dielektrischen Verluste deutlich größer, so daß bei herkömmlichen Resonatoren extrem dünne Kapillaren als Probengefäß 22 Verwendung finden, allenfalls sogenannte "Flachzellen", die sich in einer zur Schmalseite 14 parallelen Ebene befinden, die durch die Probenachse 20 läuft. Nur auf diese Weise wird erreicht, daß sich die Probensubstanz nahezu vollständig im Bereich des Minimums von E_{y} befindet. Bereits bei geringfügigem Ausweichen aus diesem Punkt minimaler elektrischer Hochfrequenzfeldstärke treten deutlich meßbare dielektrische Verluste auf. Diese führen zu einer drastischen Abnahme der Güte Q des Hohlraumresonators und damit zu einer deutlichen Verschlechterung des Meßergebnisses.

Erfindungsgemäß ist nun das Probengefäß 22 so ausgebildet, daß es eine Vielzahl langgestreckter Probenräume umfaßt, die sich beim dargestellten Ausführungsbeispiel parallel zur Probenachse 20 erstrecken.

Fig. 3 zeigt dazu als Beispiel in vergrößertem Maßstab ein Probengefäß 22a, das aus einem massiven Block besteht. Der Block kann z.B. aus Quarz bestehen. In dem Block ist eine Vielzahl von Bohrungen 32 achsparallel zueinander angeordnet.

Alternativ kann, wie Fig. 4 zeigt, auch ein Bündel von Kapillaren 34 zu einem Probengefäß 22b vereinigt werden.

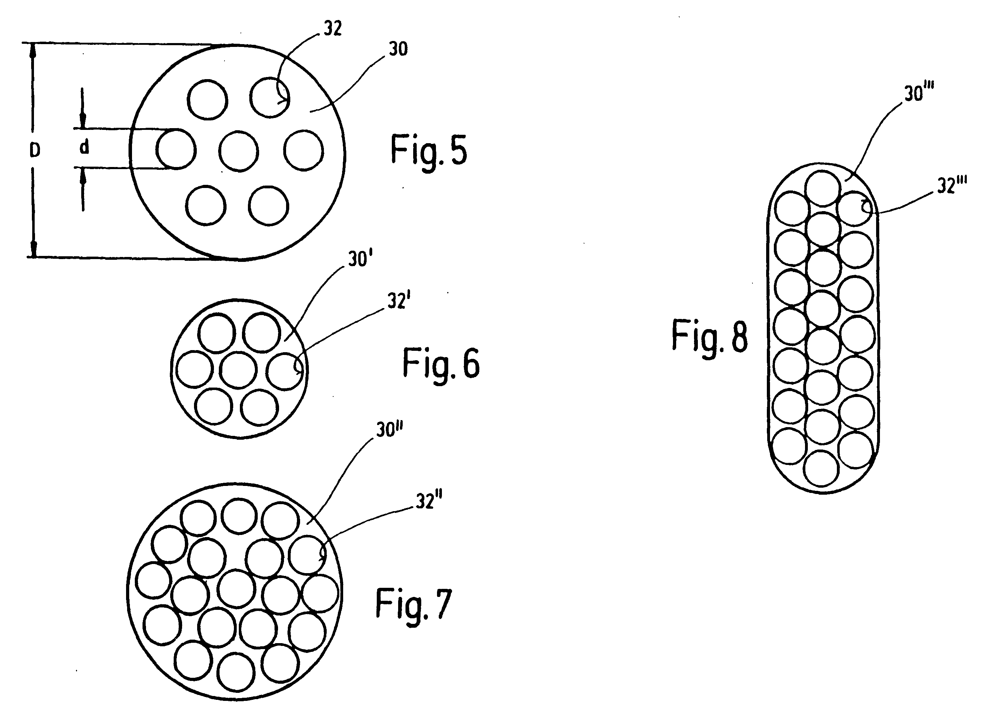

Die Fig. 5 bis 7 zeigen in Draufsicht einige mögliche Konfigurationen der Bohrungen 32, wobei Entsprechendes für die Kapillaren 34 gelten würde.

Beim Ausführungsbeispiel gemäß Fig. 5 sind in hexagonal dichtester Packung insgesamt sieben Bohrungen 32 im Block 30 angeordnet. Der Außendurchmesser D des Blocks 30 kann dabei zwischen 2,5 und 5 mm, vorzugsweise zwischen 2,8 und 3,8 mm, liegen, während der Durchmesser d der Bohrungen 32 z.B. zwischen 0,3 und 1,0 mm, vorzugsweise zwischen 0,5 und 0,8 mm, liegt. Diese Angaben beziehen sich auf eine Meßfrequenz im x-Band, bspw. 10 GHz.

Bei der Variante gemäß Fig. 6 ist der Außendurchmesser des Blocks 30' wesentlich geringer, während Anzahl und Durchmesser der Bohrungen 32' gegenüber Fig. 5 unverändert ist. Der Flächenanteil der Bohrungen 32' ist daher deutlich größer, er beträgt nämlich etwa 44 % gegenüber etwa 24 % beim Ausführungsbeispiel gemäß Fig. 5.

Die höhere Dichte der Bohrungen macht sich auch beim Ausführungsbeispiel gemäß Fig. 7 bemerkbar, wo insgesamt 19 derartige Bohrungen 32" im Block 30" angeordnet sind.

Schließlich zeigt Fig. 8 eine weitere Variante, bei der der Block 30''' nicht zylindrisch sondern vielmehr flach bzw. langgestreckt ausgebildet und ebenfalls mit einer Vielzahl von Bohrungen 32''' versehen ist.

Weitere Formgestaltungen sind ohne weiteres möglich und hängen z. B. auch von der Bauform des jeweiligen Resonators ab.

Der erfindungsgemäße Probenkopf läßt sich in vorteilhafter Weise bei industriellen Anwendungen einsetzen, insbesondere dem weiter oben im einzelnen dargestellten Beispiel der Untersuchung der Haltbarkeit von Bier. Die Erfindung ist jedoch auf diesen Anwendungsfall nicht beschränkt. sie kann allgemein auch bei fermentierten Flüssigkeiten eingesetzt werden, also z.B. auch bei Wein oder bei Molkereiprodukten.

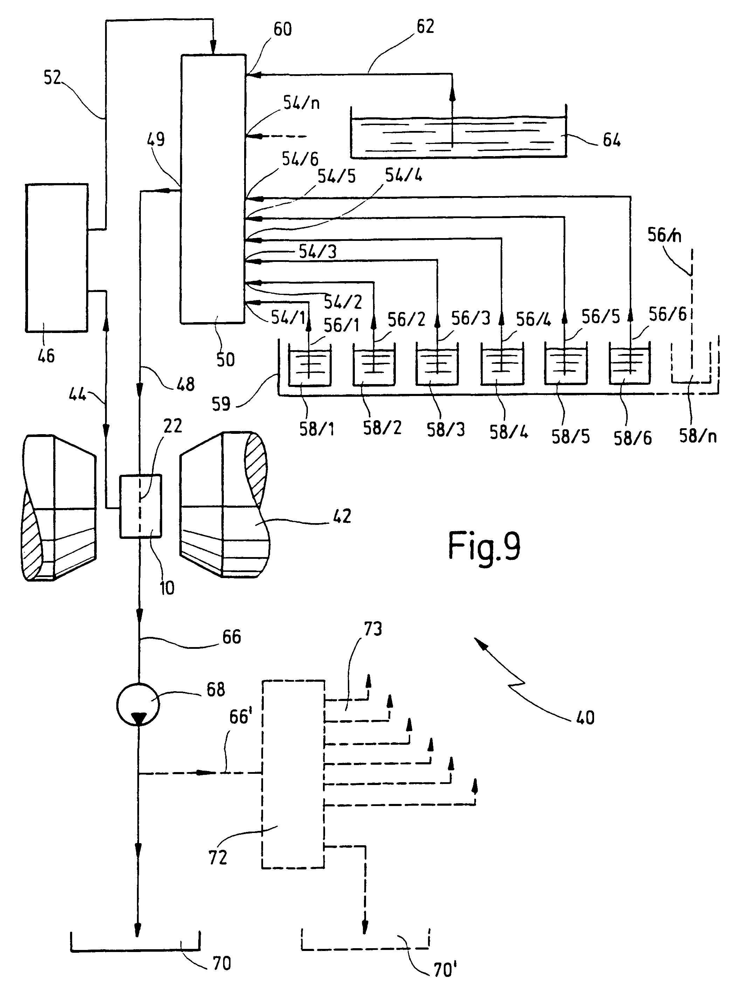

Zur Veranschaulichung dieses Verfahrens sei zunächst Bezug auf Fig. 9 genommen.

Mit 40 ist insgesamt ein im Sinne der vorliegenden Erfindung modifiziertes ESR-Spektrometer gezeigt, das zur Durchführung des erfindungsgemäßen Verfahrens geeignet und vorgesehen ist.

Das Spektrometer 40 umfaßt in herkömmlicher Weise ein Magnetsystem 42, in dem sich der Resonator 10 befindet. Eine Mikrowellenleitung 44 verbindet den Resonator 10 mit einem Spektrometer-Steuergerät 46.

Im Resonator 10 befindet sich das Probengefäß 22 in der weiter vorne beschriebenen Ausformung, das in diesem Falle als Durchflußzelle geschaltet ist.

Folglich ist in Fig. 9 oben an das Probengefäß 22 eine Zulaufleitung 48 angeschlossen. Die Zulaufleitung 48 führt zu einem Ausgang 49 eines ersten Samplers 50. Unter einem "Sampler" versteht man eine Vorrichtung, mit der Substanzen zwischen verschiedenen Probengefäßen hin- und hergefördert werden können. Ein Sampler weist dazu eine Vielzahl von Verbindungsleitungen, Ventilen, Pumpen und Steuereinrichtung auf, um beliebige Durchflußwege zwischen bestimmten Eingängen und bestimmten Ausgängen nach einem vorgegebenen Programm herzustellen.

Der erste Sampler 50 in Fig. 9 ist über eine Steuerleitung 52 mit dem Spektrometer-Steuergerät 46 verbunden.

Der erste Sampler 50 hat insgesamt n Eingänge 54/1 bis 54/n, von denen lediglich sechs, nämlich 54/1 bis 54/6 im einzelnen dargestellt sind.

An die Eingänge 54/1 bis 54/n sind Saugleitungen 56/1 bis 56/n angeschlossen, die zu Behältern 58/1 bis 58/n führen. Die Behälter 58 befinden sich insgesamt in einem Thermostaten 59. Der Thermostat 59 ist so ausgebildet, daß in den Behältern 58 eine deutlich über Raumtemperatur liegende Temperatur eingestellt werden kann, beispielsweise im Bereich zwischen 50°C und 70°C.

Zur Durchführung des erfindungsgemäßen Verfahrens sind die ersten Behälter 58 mit dem flüssigen Nahrungsmittel bzw. der fermentierten Flüssigkeit, insbesondere mit Bier befüllt. Das Probenmaterial wurde vorab mit einer Spin-Trap- oder Spin-Label-Substanz versehen oder weist eine derartige Substanz bereits intrinsisch auf.

Der erste Sampler 50 verfügt noch über einen zweiten Eingang 60, der über eine zweite Saugleitung 62 an einen zweiten Behälter 64 angeschlossen ist. Der zweite Behälter 64 ist vorzugsweise wesentlich größer als die ersten Behälter 58. Er enthält im dargestellten Ausführungsbeispiel eine Spülflüssigkeit.

Durch geeignete Ansteuerung des ersten Samplers 50 über die Steuerleitung 52 kann das Steuergerät 56 bewirken, daß aus einem der Behälter 58/1 bis 58/n oder aus dem Behälter 64 Flüssigkeit angesaugt und auf den Ausgang 49 geleitet wird.

An der in Fig. 9 unten liegenden Seite des Resonators 10 erkennt man eine Ablaufleitung 66. Die Ablaufleitung 66 führt über eine Pumpe 68, insbesondere eine Peristaltikpumpe, zu einem Ablauf 70. Der Ablauf 70 ist an ein herkömmliches Entsorgungssystem angeschlossen (nicht dargestellt).

Bei einer alternativen Ausführungsform der Erfindung kann am Ausgang der Pumpe 68 auch ein zweiter Sampler 72 vorgesehen sein. Der zweite Sampler 72 ist prinzipiell wie der erste Sampler 50 aufgebaut. Über die Ablaufleitung 66' wird dem zweiten Sampler 72 die aus dem Probengefäß 22 abgelassene Flüssigkeit zugeleitet. Über Rezirkulationsleitungen 73, die an den Ausgang des zweiten Samplers 72 angeschlossen sind, kann diese abgelassene Flüssigkeit nun gezielt an einem der Behälter 58/1 bis 58/n oder dem zweiten Behälter 64 wieder zugeführt werden.

Während also im erst genannten Fall die jeweils im Resonator 10 gemessenen Proben nach dem Ablassen über die Pumpe 68 entsorgt werden, werden sie im zweit genannten Fall über den zweiten Sampler 72 in ihre Ausgangsbehälter rezirkuliert.

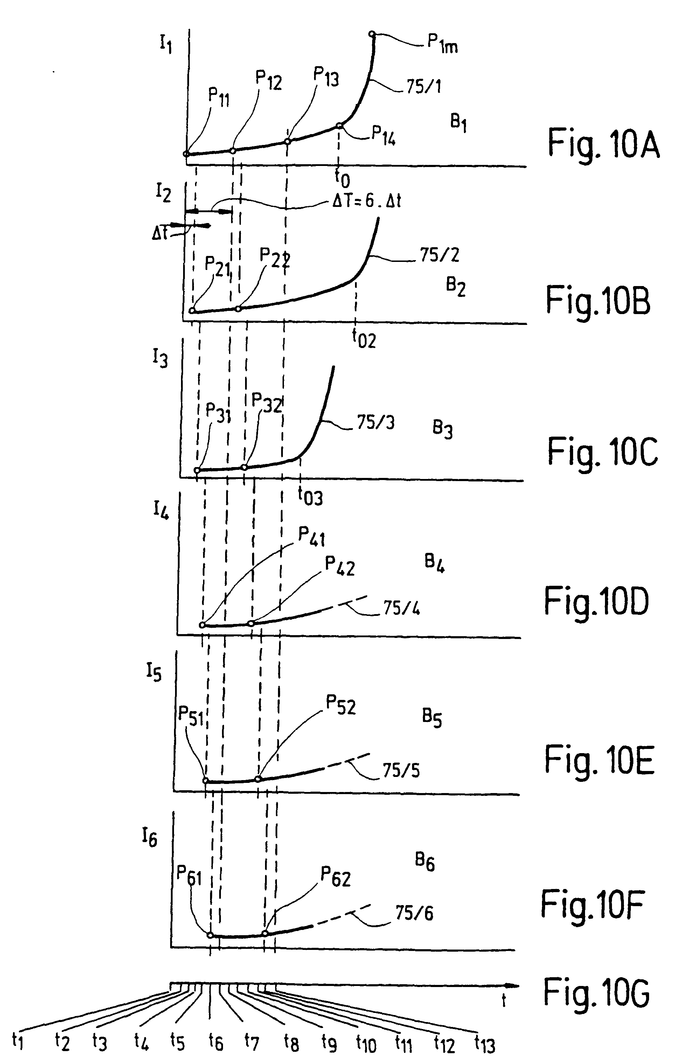

Zur Erläuterung des erfindungsgemäßen Verfahrens sei nun auf die Darstellung in den Fig. 10a bis 10g verwiesen.

Dabei stellen die Fig. 10a bis 10f sechs Diagramme dar, in denen auf der Ordinate eine Intensität I des im Resonators 10 gemessenen ESR-Signals dargestellt ist, während auf der Abszisse die Zeit t dargestellt ist. Fig. 10g zeigt dazu verschiedene Zeitpunkte t₁ bis t₁₃, auf die noch eingegangen werden wird. Diese Zeitpunkte sind für alle Darstellungen der Fig. 10a bis 10f gemeinsam.

In Fig. 10a ist ein erstes Diagramm 75/1 aufgetragen. Das Diagramm 75/1 umfaßt einen Kurvenzug, der allmählich von einem ersten Punkt P₁₁ über einen zweiten Punkt P₁₂ und einen dritten Punkt P₁₃ zu einem vierten Punkt P₁₄ ansteigt und dort zu einem Zeitpunkt t₀ einen überproportionalen Anstieg aufweist. Nach dem vierten Punkt P₁₄ folgen noch weitere Meßpunkte (nicht dargestellt) bis schließlich nach m Messungen das Diagramm 75/1 im m-ten Punkt P₁ₘ endet.

Wie sich aus den ganz im Eingang der vorliegenden Anmeldung zitierten drei Druckschriften ergibt, ist das Diagramm 75/1 charakteristisch für eine Haltbarkeitsmessung an Bier. Danach zeigt nämlich eine thermisch gestreßte Bierprobe bei zeitlich aufeinander folgenden Messungen zunächst einen langsamen Anstieg der Intensität I des ESR-Signals, während zu einem bestimmten Zeitpunkt (hier: t₀) der Anstieg überproportional zunimmt. Die Lage dieses Zeitpunktes t₀ ist ein Maß dafür, wie haltbar das Bier ist.

Im folgenden ist angenommen, daß mit der in Fig. 9 beschriebenen Anordnung parallel sechs verschiedene Biersorten aus den sechs Behältern 58/1 bis 58/6 gemessen werden sollen. Die sechs Biersorten sind in den Darstellungen der Fig. 10a bis 10f mit B₁ bis B₆ bezeichnet.

Das Meßprogramm beginnt zum Zeitpunkt t₁ (Fig. 10g). Zum Zeitpunkt t₁ wird über geeignete Ansteuerung des ersten Samplers 50 eine Probe aus dem ersten Behälter 58/1 entnommen, in dem sich die Biersorte B₁ befindet. Mit dieser Probe wird das Probengefäß 22 im Resonator 10 befüllt. Die nachfolgende ESR-Messung ergibt eine Intensität I₁, die als erster Meßpunkt P₁₁ im Diagramm 75/1 von Fig. 10a aufgetragen wird.

Nach Abschluß dieser ersten Messung, die eine Zeit Δt (Fig.10 b) in Anspruch genommen hat, wird das Probengefäß 22 entleert, wobei die Probe entweder im Ablauf 70 entsorgt oder über den zweiten Sampler 72 in den ersten Behälter 58/1 rezirkuliert wird. Zweckmäßigerweise wird das Probengefäß 22 anschließend gespült, indem über den ersten Sampler 50 aus dem zweiten Behälter 64 eine entsprechende Menge an Spülflüssigkeit durch das Probengefäß 22 geschickt wird. Diese Spülflüssigkeit wird dann im Ablauf 70 (bzw. 70') entsorgt.

Für die nächste Messung wird eine Probe aus dem zweiten Behälter 58/2 entnommen, in der sich die Biersorte B2 befindet. Die anschließende ESR-Messung führt zu einer Intensität I₂, die als Meßpunkt P₂₁ im Diagramm 75/2 von Fig. 10b aufgetragen wird. Es wird also für jede Biersorte B₁ bis B₆ ein eigenes Diagramm 75/1 bis 75/6 angelegt.

In der Annahme, daß alle Meßvorgänge gleich schnell ablaufen, wird nun jeweils ein Zeitintervall Δt später eine nachfolgende Messung an der jeweils nächsten Biersorte durchgeführt. Auf den Meßpunkt P₂₁ in Fig. 10b folgt also nach Δt ein Meßpunkt P₃₁ in Fig. 10c, der einen Meßpunkt P₄₁ in Fig. 10d, anschließend ein Meßpunkt P₅₁ in Fig. 10e und schließlich ein Meßpunkt P₆₁ in Fig. 10f. Nun sind alle sechs Biersorten B₁ bis B₆ mit jeweils einem Meßpunkt P₁₁ bis P₆₁ durchgemessen.

Nach einem weiteren Zeitintervall Δt kann nun ein zweiter Meßpunkt der ersten Biersorte B₁ gemessen werden, indem über den ersten Sampler 50 wieder aus dem ersten Behälter 58/1 eine Probe entnommen wird. Der entsprechende Meßpunkt ist in Fig. 10a mit P₁₂ bezeichnet.

Das Zeitintervall zwischen den Meßpunkten P₁₁ und P₁₂ in Fig. 10a ist mit ΔT bezeichnet. Im dargestellten Ausführungsbeispiel ist ΔT sechs mal so lang wie Δt, weil insgesamt sechs Biersorten nacheinander durchgemessen wurden.

Wie man aus der einschlägigen Literatur weiß, die eingangs zitiert wurde, ändert sich das Intensitätsdiagramm anfangs nur wenig, so daß man sich zwischen den einzelnen Meßpunkten (P₁₁ - P₁₂ - P₁₃) genügend Zeit lassen kann, beispielsweise fünf oder zehn Minuten. Während nun bei herkömmlichen Messungen während dieser Zeit die Meßapparatur nicht genutzt wurde, wird beim erfindungsgemäßen Verfahren in der beschriebenen Weise erreicht, daß diese Meßpausen für Messungen an weiteren Proben anderer Biersorten genutzt werden können. Je nach Einzelfall kann man daher so viele parallel ablaufende Messungen ineinander verschachteln, daß die Abstände ΔT gerade das maximal zulässige Maß erreichen.

In der vorstehend beschriebenen Weise wird nun zyklisch weiter gemessen, so daß nach den ersten Meßpunkten P₁₁ bis P₆₁ der sechs Biersorten B₁ bis B₆ zunächst zweite Meßpunkte P₁₂ bis P₆₂, dann dritte Meßpunkte P₁₃ ... usw. gemessen werden, bis schließlich nach m Meßpunkten die letzten Meßpunkte P₁ₘ bis P₆ₘ gemessen sind und damit insgesamt sechs Diagramme und damit sechs komplette Messungen vorliegen.

Aus der Darstellung in Fig. 10g erkennt man, daß die Einzelmessungen jeweils mit gleichem zeitlichem Abstand ablaufen, wobei der erste Meßzyklus der ersten Punkte P₁₁ bis P₆₁ zum Zeitpunkt t₆ und der zweite Zyklus zum Zeitpunkt t₁₂ abgeschlossen wurde, so daß zum Zeitpunkt t₁₃ der dritte Meßpunkt t₁₃ im ersten Diagramm 75/1 ausgemessen werden kann.

Natürlich sind auch insoweit Variationen möglich, beispielsweise dann, wenn so stark unterschiedliche Biersorten gemessen werden, daß unterschiedliche Einzelmessungszeiten eingestellt werden müssen. Dies ändert jedoch nichts am Prinzip der erfindungsgemäßen Vorgehensweise.

## Patentansprüche

1. Verfahren zum Untersuchen der Haltbarkeit von flüssigen Nahrungsmitteln mittels Elektronenspinresonanz (ESR), bei dem eine Probe des Nahrungsmittels über einen längeren Zeitraum einer gegenüber Raumtemperatur erhöhten Temperatur ausgesetzt wird, wobei während des Zeitraumes in vorbestimmten zeitlichen Abständen (ΔT) ein ESR-Signal der Probe gemessen, die Intensität (I) des ESR-Signals über der Zeit (t) aufgetragen und der Zeitpunkt (t₀₁, t₀₂, t₀₃) eines überproportionalen Anstieges der Intensität (I) erfaßt wird, **dadurch gekennzeichnet, daß** mittels eines Steuergeräts (46) eine vorbestimmte Anzahl n von Proben unterschiedlicher Nahrungsmittel untersucht wird, indem in einem für die Proben gemeinsamen Probengefäß (22) die folgenden Schritte automatisiert und für verschiedene Proben zeitlich ineinander verschachtelt ausgeführt werden:
a) Einfüllen einer ersten Probe eines ersten Nahrungsmittels in das Probengefäß (22);
b) Untersuchen der ersten Probe mittels ESR und Erfassen der Intensität (I) des ESR-Signals;
c) Eintragen der in Schritt b) erfaßten Intensität (I) als erster Meßpunkt (P₁₁) in ein erstes Diagramm (75/1);
d) Ablassen der ersten Probe;
e) n-1-maliges Wiederholen der Schritte a) bis d) mit den n-1 Proben der anderen Nahrungsmittel, wobei in Schritt c) die erfaßten Intensitäten für jedes Nahrungsmittel als erste Punkte (P₂₁ bis Pₙ₁) in ein separates Diagramm (75/2 bis 75/n) eingetragen werden, und die Zahl n so bemessen ist, daß die n-malige Ausführung der Schritte a) bis d) im wesentlichen mit dem vorbestimmten zeitlichen Abstand (ΔT) übereinstimmt;
f) Einfüllen einer weiteren ersten Probe des ersten Nahrungsmittels in das Probengefäß (22);
g) Untersuchen der weiteren ersten Probe mittels ESR und Erfassen der Intensität (I) des ESR-Signals;
h) Eintragen der in Schritt g) erfaßten Intensität (I) als zweiter Meßpunkt (P₁₂) in das erste Diagramm (75/1);
i) Ablassen der weiteren ersten Probe;
j) n-1-maliges Wiederholen der Schritte e) bis i) mit den n-1 Proben der anderen Nahrungsmittel, wobei in Schritt h) die erfaßten Intensitäten für jedes Nahrungsmittel als zweite Punkte (P₂₂ bis Pₙ₂) in die separaten Diagramme (75/2 bis 75/n) eingetragen werden; und
k) Wiederholen der Schritte e) bis j) für dritte und weitere Meßpunkte, bis eine vorbestimmte Anzahl m an Meßpunkten je Diagramm (75) erreicht ist.

2. Verfahren nach Anspruch 1, **dadurch gekennzeichnet, daß** die Probe vorab mit einer Spin-Trap-Substanz versehen wird.

3. Verfahren nach Anspruch 1, **dadurch gekennzeichnet, daß** die Probe vorab mit einer Spin-Label-Substanz versehen wird.

4. Verfahren nach Anspruch 1, **dadurch gekennzeichnet, daß** eine Probe mit einer intrinsisch vorhandenen Spin-Trap- oder Spin-Label-Substanz verwendet wird.

5. Verfahren nach einem oder mehreren der Ansprüche 1 bis 4, **dadurch gekennzeichnet, daß** in den Schritten d) und i) die Proben nach dem Ablassen rezirkuliert werden, derart, daß alle Proben eines bestimmten Nahrungsmittels durch die selbe Probe dargestellt werden.

6. Verfahren nach einem oder mehreren der Ansprüche 1 bis 4, **dadurch gekennzeichnet, daß** in den Schritten d) und i) die Proben nach dem Ablassen entsorgt werden, derart, daß die Proben eines bestimmten Nahrungsmittels als unterschiedliche Proben aus einem Vorrat des bestimmten Nahrungsmittels entnommen werden.

7. Verfahren nach einem oder mehreren der Ansprüche 1 bis 6, **dadurch gekennzeichnet, daß** das Probengefäß (22) nach Schritt d) und/oder i) gespült wird.

8. Verfahren nach einem oder mehreren der Ansprüche 1 bis 7, **dadurch gekennzeichnet, daß** die Proben in einem Resonator (10) gemessen werden, in dem ein elektromagnetisches Feld (H, E) ausbreitungsfähig ist, wobei das Probengefäß (22) langgestreckt und im Resonator (10) in Richtung der magnetischen Hochfrequenzfeldstärke (Hx), und zwar an einem Ort (20) maximaler magnetischer und minimaler elektrischer Hochfrequenzfeldstärke (Hx, Ey) angeordnet ist, daß die im Probengefäß (22) enthaltene Probe des Nahrungsmittels in einer Richtung zunehmender elektrischer Hochfrequenzfeldstärke (Ey) minimale Abmessungen aufweist, und daß die Proben in einem Probengefäß (22) gemessen werden, das mit einer Vielzahl langgestreckter Probenräume mit minimalen radialen Abmessungen versehen ist.

9. Verfahren nach Anspruch 8, **dadurch gekennzeichnet, daß** die Probenräume parallel angeordnet sind, und daß die Probe an einem Ende der Probenräume eingefüllt und an einem gegenüberliegenden Ende der Probenräume abgelassen wird.

10. Verfahren nach Anspruch 8, **dadurch gekennzeichnet, daß** die Probenräume in Reihe angeordnet sind, und daß die Probe an dem offenen Ende des ersten Probenraumes in der Reihe eingefüllt und an dem offenen Ende des letzten Probenraumes in der Reihe abgelassen wird.

11. Verfahren nach einem oder mehreren der Ansprüche 1 bis 10, **dadurch gekennzeichnet, daß** das flüssige Nahrungsmittel Bier ist.

12. Vorrichtung zum Untersuchen der Haltbarkeit von flüssigen Nahrungsmitteln mittels Elektronenspinresonanz (ESR), wobei eine Probe des Nahrungsmittels über einen längeren Zeitraum einer gegenüber Raumtemperatur erhöhten Temperatur ausgesetzt und während des Zeitraumes in vorbestimmten zeitlichen Abständen (ΔT) ein ESR-Signal der Probe gemessen, die Intensität (I) des ESR-Signals über der Zeit (t) aufgetragen und der Zeitpunkt (t₀₁, t₀₂, t₀₃) eines überproportionalen Anstieges der Intensität (I) erfaßt wird, **dadurch gekennzeichnet, daß** zum zeitlich ineinander verschachtelten, automatisierten Untersuchen einer vorbestimmten Anzahl n von Proben unterschiedlicher Nahrungsmittel mittels eines Steuergeräts (46) ein für die Proben gemeinsames Probengefäß (22) vorgesehen ist und die Vorrichtung umfaßt:
a) Mittel zum Einfüllen einer ersten Probe eines ersten Nahrungsmittels in das Probengefäß (22);
b) Mittel zum Untersuchen der ersten Probe mittels ESR und Erfassen der Intensität (I) des ESR-Signals;
c) Mittel zum Eintragen der in Schritt b) erfaßten Intensität (I) als erster Meßpunkt (P₁₁) in ein erstes Diagramm (75/1);
d) Mittel zum Ablassen der ersten Probe;
e) Mittel zum n-1-maligen Wiederholen der Schritte a) bis d) mit den n-1 Proben der anderen Nahrungsmittel, wobei in Schritt c) die erfaßten Intensitäten für jedes Nahrungsmittel als erste Punkte (P₂₁ bis Pₙ₁) in ein separates Diagramm (75/2 bis 75/n) eingetragen werden, und die Zahl n so bemessen ist, daß die n-malige Ausführung der Schritte a) bis d) im wesentlichen mit dem vorbestimmten zeitlichen Abstand (ΔT) übereinstimmt;
f) Mittel zum Einfüllen einer weiteren ersten Probe des ersten Nahrungsmittels in das Probengefäß (22);
g) Mittel zum Untersuchen der weiteren ersten Probe mittels ESR und Erfassen der Intensität (I) des ESR-Signals;
h) Mittel zum Eintragen der in Schritt g) erfaßten Intensität (I) als zweiter Meßpunkt (P₁₂) in das erste Diagramm (75/1);
i) Mittel zum Ablassen der weiteren ersten Probe;
j) Mittel zum n-1-maligen Wiederholen der Schritte e) bis i) mit den n-1 Proben der anderen Nahrungsmittel, wobei in Schritt h) die erfaßten Intensitäten für jedes Nahrungsmittel als zweite Punkte (P₂₂ bis Pₙ₂) in die separaten Diagramme (75/2 bis 75/n) eingetragen werden; und
k) Mittel zum Wiederholen der Schritte e) bis j) für dritte und weitere Meßpunkte, bis eine vorbestimmte Anzahl m an Meßpunkten je Diagramm (75) erreicht ist.

13. Vorrichtung nach Anspruch 12, **dadurch gekennzeichnet, daß** die Probe vorab mit einer Spin-Trap-Substanz versehen wird.

14. Vorrichtung nach Anspruch 12, **dadurch gekennzeichnet, daß** die Probe vorab mit einer Spin-Label-Substanz versehen wird.

15. Vorrichtung nach Anspruch 12, **dadurch gekennzeichnet, daß** eine Probe mit einer intrinsisch vorhandenen Spin-Trap- oder Spin-Label-Substanz verwendet wird.

16. Vorrichtung nach einem oder mehreren der Ansprüche 12 bis 15, **gekennzeichnet durch** Mittel, die in den Schritten d) und i) die Proben nach dem Ablassen rezirkulieren, derart, daß alle Proben eines bestimmten Nahrungsmittels **durch** die selbe Probe dargestellt werden.

17. Vorrichtung nach einem oder mehreren der Ansprüche 12 bis 15, **gekennzeichnet durch** Mittel, die in den Schritten d) und i) die Proben nach dem Ablassen entsorgen, derart, daß die Proben eines bestimmten Nahrungsmittels als unterschiedliche Proben aus einem Vorrat des bestimmten Nahrungsmittels entnommen werden.

18. Vorrichtung nach einem oder mehreren der Ansprüche 12 bis 17, **gekennzeichnet durch** einen Resonator (10), in dem ein elektromagnetisches Feld (H, E) ausbreitungsfähig ist, wobei das Probengefäß (22) langgestreckt und im Resonator (10) in Richtung der magnetischen Hochfrequenzfeldstärke (Hx), und zwar an einem Ort (20) maximaler magnetischer und minimaler elektrischer Hochfrequenzfeldstärke (Hx, Ey) angeordnet ist, wobei die im Probengefäß (22) enthaltene Probe des Nahrungsmittels in einer Richtung zunehmender elektrischer Hochfrequenzfeldstärke (Ey) minimale Abmessungen aufweist, und ferner die Proben in einem Probengefäß (22) aufgenommen sind, das mit einer Vielzahl langgestreckter Probenräume mit minimalen radialen Abmessungen versehen ist.

19. Vorrichtung nach einem oder mehreren der Ansprüche 12 bis 18, **dadurch gekennzeichnet, daß** das Probengefäß (22a) einen Block (30) umfaßt, der mit einer Vielzahl achsparalleler Bohrungen (32) versehen ist.

20. Vorrichtung nach Anspruch 19, **dadurch gekennzeichnet, daß** der Block (30, 30', 30") im wesentlichen zylindrisch ist.

21. Vorrichtung nach Anspruch 19, **dadurch gekennzeichnet, daß** der Block (30''') im wesentlichen flach ist.

22. Vorrichtung nach einem oder mehreren der Ansprüche 12 bis 18, **dadurch gekennzeichnet, daß** das Probengefäß (22b) ein Bündel von Kapillaren umfaßt.

23. Vorrichtung nach einem oder mehreren der Ansprüche 12 bis 22, **dadurch gekennzeichnet, daß** das Verhältnis der Summe der radialen Querschnittsflächen der Probenräume zur Gesamtquerschnittsfläche des Probengefäßes (22) zwischen 0,2 und 0,6 liegt.

24. Vorrichtung nach einem oder mehreren der Ansprüche 12 bis 23, **dadurch gekennzeichnet, daß** die Probenräume im wesentlichen zylindrisch sind.

25. Vorrichtung nach Anspruch 24, **dadurch gekennzeichnet, daß** bei einer Frequenz des elektromagnetischen Feldes (H, E) von etwa 10 GHz (X-Band) der Durchmesser der Probenräume zwischen 0,3 und 1,0 mm, vorzugsweise zwischen 0,5 und 0,8 mm liegt.

26. Vorrichtung nach Anspruch 25, **dadurch gekennzeichnet, daß** bei einem im wesentlichen zylindrischen Probengefäß (22) dessen Außendurchmesser zwischen 2,5 und 5 mm, vorzugsweise zwischen 2,8 und 3,8 mm, liegt.

27. Vorrichtung nach Anspruch 26, **dadurch gekennzeichnet, daß** sieben oder neunzehn Probenräume in hexagonal dichtester Packung im Probengefäß (22) vorgesehen sind.

28. Vorrichtung nach einem oder mehreren der Ansprüche 12 bis 27, **dadurch gekennzeichnet, daß** dem Probengefäß (22) Mitttel zum Spülen der Probenräume zugeordnet sind.

29. Vorrichtung nach einem oder mehreren der Ansprüche 18 bis 28, **dadurch gekennzeichnet, daß** die Probenräume parallel angeordnet sind, derart, daß daß die Probe an einem Ende der Probenräume einfüllbar und an einem gegenüberliegenden Ende der Probenräume ablassbar ist.

30. Vorrichtung nach einem oder mehreren der Ansprüche 18 bis 28, **dadurch gekennzeichnet, daß** die Probenräume in Reihe angeordnet sind, und daß die Probe an dem offenen Ende des ersten Probenraumes in der Reihe einfüllbar und an dem offenen Ende des letzten Probenraumes in der Reihe ablassbar ist.

31. Vorrichtung nach Anspruch 29 oder 30, **dadurch gekennzeichnet, daß** eine Pumpe (68) an das Ablaßende der Probenräume angeschlossen ist.

32. Vorrichtung nach Anspruch 31, **dadurch gekennzeichnet, daß** die Pumpe (68) eine peristaltische Pumpe ist.

33. Vorrichtung nach einem oder mehreren der Ansprüche 29 bis 32, **dadurch gekennzeichnet, daß** an das Einfüllende der Probenräume ein Ausgang (49) eines Samplers (50) angeschlossen, und daß Eingänge (54/1 bis 54/n) des Samplers (50) mit einer Mehrzahl von Behältern (58/1 bis 58/n) verbunden sind, die mit den unterschiedlichen Nahrungsmitteln befüllt sind.

34. Vorrichtung nach Anspruch 33, **dadurch gekennzeichnet, daß** ein weiterer Eingang (60) des Samplers (50) an einen mit Spülflüssigkeit befüllbaren Behälter (64) angeschlossen ist.

## Claims

1. A method for investigating the imperishability of liquid foodstuffs by means of electron spin resonance (ESR), wherein a sample of the foodstuff is exposed to an elevated temperature, as compared to room temperature, for an extended period of time, wherein during the period of time an ESR signal of the sample is measured in predetermined time intervals (At), the intensity (I) of the ESR signal is plotted vs. time (t) and the moment in time (t₀₁, t₀₂, t₀₃) is detected when the intensity (I) shows a superproportional increase, **characterized in that** by means of a control unit (46) a predetermined number n of samples of different foodstuffs is investigated by executing the following steps within a common sample vessel (22) in an automatized and, for different samples, interlocked-in-time manner:
a) filling a first sample of a first foodstuff into the sample vessel (22);
b) investigating the first sample by means of ESR and measuring the intensity (I) of the ESR signal;
c) plotting the intensity (I) measured in step b) as a first measuring point (P₁₁) in a first diagram (75/1);
d) discharging the first sample;
e) repeating n-1 times steps a) through d) with the n-1 samples of the other foodstuffs, wherein in step c) the measured intensities of each foodstuff are plotted into separate diagrams (75/2 through 75/n) as first points (P₂₁ through Pₙ₁), the number n being dimensioned such that executing steps a) through d) n times corresponds essentially to the predetermined time interval (Δt);
f) filling another first sample of the first foodstuff into the sample vessel (22);
g) investigating the further first sample by means of ESR and measuring the intensity (I) of the ESR signal;
h) plotting the intensity measured in step g) as a second measuring point (P₁₂) into the first diagram (75/1);
i) discharging the further first sample;
j) repeating n-1 times steps e) through i) with the n-1 samples of the other foodstuffs, wherein in step h) the measured intensities of each foodstuff are plotted into the separate diagrams (75/2 through 75/n) as second points (P₂₂ through Pₙ₂); and
k) repeating steps e) through j) for third and more measuring points until a predetermined number m of measuring points per diagram has been attained.

2. The method of claim 1, **characterized in that** a spin-trap substance is added to the sample beforehand.

3. The method of claim 1, **characterized in that** a spin-label substance is added to the sample beforehand.

4. The method of claim 1, **characterized in that** a sample with an intrinsic spin-trap or spin-label substance is used.

5. The method of any of claims 1 to 4, **characterized in that** in steps d) and i) the samples are recirculated after discharging, such that all samples of a specific foodstuff are represented by the same sample.

6. The method of any of claims 1 to 4, **characterized in that** in steps d) and i) the samples are disposed of after discharging, such that the samples of a specific foodstuff are taken as individual samples from a supply of the specific foodstuff.

7. The method of any of claims 1 to 6, **characterized in that** the sample vessel (22) is rinsed after step d) and/or i).

8. The method of any of claims 1 to 7, **characterized in that** the samples are measured in a resonator (10) adapted to allow propagation of an electromagnetic field (H, E), the sample vessel (22) being elongate and being located within the resonator (10) along the direction of the magnetic rf field strength (Hx) at the location of maximum magnetic rf field strength (Hx) and of minimum electric rf field strength (Ey), that the foodstuff sample contained in the sample vessel (22) has minimum dimensions in the direction of increasing electric rf field strength (Ey), and that the samples are measured in a sample vessel (22) having a plurality of elongate sample areas with minimum radial dimensions.

9. The method of claim 8, **characterized in that** the sample areas are arranged parallel, and that the sample is filled into one end of the sample areas and is discharged from the opposite end of the sample areas.

10. The method of claim 8, **characterized in that** the sample areas are arranged in series, and that the sample is filled into an open end of the first sample area within the series and is discharged from the open end of the last sample area within the series.

11. The method of any of claims 1 to 10, **characterized in that** the liquid foodstuff is beer.

12. An apparatus for investigating the imperishability of liquid foodstuffs by means of electron spin resonance (ESR), wherein a sample of the foodstuff is exposed to an elevated temperature, as compared to room temperature, for an extended period of time, wherein during the period of time an ESR signal of the sample is measured in predetermined time intervals (Δt), the intensity (I) of the ESR signal is plotted vs. time and the moment in time (t₀₁, t₀₂, t₀₃) is detected when the intensity (I) shows a super-proportional increase, **characterized in that** for investigating a predetermined number n of samples of different foodstuffs by means of a control unit (46) in an automatized and interlocked-in-time manner, a common sample vessel (22) is provided, and that the apparatus comprises:
a) means for filling a first sample of a first foodstuff into the sample vessel (22);
b) means for investigating the first sample by means of ESR and measuring the intensity (I) of the ESR signal;
c) means for plotting the intensity (I) measured in step b) as a first measuring point (P₁₁) in a first diagram (75/1);
d) means for discharging the first sample;
e) means for repeating n-1 times steps a) through d) with the n-1 samples of the other foodstuffs, wherein in step c) the measured intensities of each foodstuff are plotted into separate diagrams (75/2 through 75/n) as first points (P₂₁ through Pₙ₁), the number n being dimensioned such that executing steps a) through d) n times corresponds essentially to the predetermined time interval (Δt);
f) means for filling another first sample of the first foodstuff into the sample vessel (22);
g) means for investigating the further first sample by means of ESR and measuring the intensity (I) of the ESR signal;
h) means for plotting the intensity measured in step g) as a second measuring point (P₁₂) into the first diagram (75/1);
i) means for discharging the further first sample;
j) means for repeating n-1 times steps e) through i) with the n-1 samples of the other foodstuffs, wherein in step h) the measured intensities of each foodstuff are plotted into the separate diagrams (75/2 through 75/n) as second points (P₂₂ through Pₙ₂); and
k) means for repeating steps e) through j) for third and more measuring points until a predetermined number m of measuring points per diagram has been attained.

13. The method of claim 12, **characterized in that** a spin-trap substance is added to the sample beforehand.

14. The method of claim 12, **characterized in that** a spin-label substance is added to the sample beforehand.

15. The method of claim 12, **characterized in that** a sample with an intrinsic spin-trap or spin-label substance is used.

16. The apparatus of any of claims 12 to 15, **characterized by** means which in steps d) and i) recirculate the samples after discharging, such that all samples of a specific foodstuff are represented by the same sample.

17. The apparatus of any of claims 12 to 15, **characterized by** means which in steps d) and i) dispose of the samples after discharging, such that the samples of a specific foodstuff are taken as individual samples from a supply of the specific foodstuff.

18. The apparatus of any of claims 12 to 17, **characterized by** a resonator (10) adapted to allow propagation of an electromagnetic field (H, E), the sample vessel (22) being elongate and being located within the resonator (10) along the direction of the magnetic rf field strength (Hx) at the location of maximum magnetic rf field strength (Hx) and of minimum electric rf field strength (Ey), that the foodstuff sample contained in the sample container (22) has minimum dimensions in the direction of increasing electric rf field strength (Ey), and that the samples are measured in a sample container (22) having a plurality of elongate sample areas with minimum radial dimensions.

19. The apparatus of any of claims 12 to 18, **characterized in that** the sample vessel (22a) comprises a block (30) having a plurality of axial bores (32).

20. The apparatus of claim 19, **characterized in that** the block (30, 30', 30") is essentially cylindrical.

21. The apparatus of claim 19, **characterized in that** the block (30''') is essentially flat.

22. The apparatus of any of claims 12 to 18, **characterized in that** the sample vessel (22b) comprises a bundle of capillaries.

23. The apparatus of any of claims 12 to 22, **characterized in that** the ratio of the sum of the radial cross-sectional areas of the sample areas and the entire cross-sectional area of the sample vessel (22) is between 0.2 and 0.6.

24. The apparatus of any of claims 12 to 23, **characterized in that** the sample areas are essentially cylindrical.

25. The apparatus of claim 24, **characterized in that** at a frequency of the electromagnetic field (H, E) of about 10 GHz (X-Band) the diameter of the sample areas is between 0.3 and 1.0 mm, preferably between 0.5 and 0.8 mm.

26. The apparatus of claim 25, **characterized in that** for an essentially cylindrical sample vessel (22) the outer diameter is between 2.5 and 5 mm, preferably between 2.8 and 3.8 mm.

27. The apparatus of claim 26, **characterized in that** seven or nineteen sample areas are provided within the sample vessel (22) in a hexagonal dense packing.

28. The apparatus of any of claims 12 to 27, **characterized in that** means for rinsing the sample areas are associated to the sample vessel (22).

29. The apparatus of any of claims 18 to 28, **characterized in that** the sample areas are arranged parallel such that the sample may be filled into one end of the sample areas and is discharged from the opposite end of the sample areas.

30. The apparatus of any of claims 18 to 28, **characterized in that** the sample areas are arranged in series, and that the sample may be filled into an open end of the first sample area within the series and is discharged from the open end of the last sample area within the series.

31. The apparatus of claim 29 or 30, **characterized in that** a pump (68) is connected to the discharge end of the sample areas.

32. The apparatus of claim 31, **characterized in that** the pump (68) is a peristaltic pump.

33. The apparatus of any of claims 29 to 32, **characterized in that** the filling-in end of the sample areas is connected to an output (49) of a sampler (50), and that inputs (54/1 through 54/n) of the sampler (50) are connected to a plurality of containers (58/1 through 58/n) being filled with different foodstuffs.

34. The apparatus of claim 33, **characterized in that** a further input (60) of the sampler (50) is connected to a container (64) adapted to be filled with a rinsing liquid.

## Revendications

1. Procédé d'analyse de la durée de conservation de produits alimentaires liquides par résonance de spin électronique (ESR), dans lequel un échantillon du produit alimentaire est soumis à une température supérieure à la température ambiante pendant une durée assez longue, un signal ESR de l'échantillon étant mesuré pendant cette durée, à intervalles de temps (ΔT) déterminés, l'intensité (I) du signal ESR étant portée en fonction du temps (t) et l'instant (t₀₁, t₀₂, t₀₃) d'une croissance surproportionnelle de l'intensité (I) étant enregistrée, **caractérisé en ce qu'**on analyse, au moyen d'un appareil de commande (46), un nombre n prédéterminé d'échantillons de produits alimentaires différents, les étapes suivantes étant exécutées de manière automatisée et, pour différents échantillons, intercalée en temps dans un récipient à échantillons (22) commun aux échantillons :
a) introduction d'un premier échantillon d'un premier produit alimentaire dans le récipient à échantillons (22) ;
b) analyse du premier échantillon par ESR et enregistrement de l'intensité (I) du signal ESR ;
c) report de l'intensité (I) enregistrée à l'état b), comme premier point de mesure (P₁₁) dans un premier diagramme (75/1) ;
d) évacuation du premier échantillon ;
e) répétition n-1 fois des étapes a) à d) avec les n-1 échantillons des autres produits alimentaires, à l'étape c) les intensités enregistrées pour chaque produit alimentaire étant reportées comme premiers points (P₂₁ à Pₙ₁) dans un diagramme (75/2 à 75/n) séparé, et le nombre n étant tel que la n-1^{ième} répétition des étapes a) à d) coïncide sensiblement avec l'intervalle de temps (ΔT) prédéterminé ;
f) introduction d'un autre premier échantillon du premier produit alimentaire dans le récipient à échantillons (22) ;
g) analyse de l'autre premier échantillon par ESR et enregistrement de l'intensité (I) du signal ESR ;
h) report de l'intensité (I) enregistrée à l'étape g) comme deuxième point de mesure P₁₂ dans le premier diagramme (75/1) ;
i) évacuation de l'autre premier échantillon ;
j) n-1^{ième} répétition des étapes e) à i) avec les n-1 échantillons des autres produits alimentaires, à l'étape h), les intensités enregistrées pour chaque produit alimentaire étant reportées comme deuxièmes points (P₂₂ à Pₙ₂) dans les diagrammes (75/2 à 75/n) séparés ; et
k) répétition des étapes e) à j) pour des troisièmes et autres points de mesure jusqu'à un nombre m prédéterminé de points de mesure par diagramme (75).

2. Procédé selon la revendication 1, **caractérisé en ce que** l'échantillon est pourvu au préalable d'une substance spin-trap.

3. Procédé selon la revendication 1, **caractérisé en ce que** l'échantillon est pourvu au préalable d'une substance spin-label.

4. Procédé selon la revendication 1, **caractérisé en ce qu'**on utilise un échantillon avec une substance spin-trap ou spin-label présente de manière intrinsèque.

5. Procédé selon une ou plusieurs des revendications 1 à 4, **caractérisé en ce qu'**au cours des étapes d) et i), les échantillons sont remis en circulation après évacuation, de manière que tous les échantillons d'un produit alimentaire déterminé soient représentés par le même échantillon.

6. Procédé selon une ou plusieurs des revendications 1 à 4, **caractérisé en ce qu'**au cours des étapes d) et i), les échantillons sont éliminés après évacuation, de manière que les échantillons d'un produit alimentaire déterminé soient prélevés en tant qu'échantillons différents d'une réserve du produit alimentaire déterminé.

7. Procédé selon une ou plusieurs des revendications 1 à 6, **caractérisé en ce que** le récipient à échantillons (22) est lavé après l'étape d) et/ou i).

8. Procédé selon une ou plusieurs des revendications 1 à 7, **caractérisé en ce que** les échantillons sont mesurés dans un résonateur (10) dans lequel un champ électromagnétique (H, E) est susceptible de se propager, le récipient à échantillons (22) étant allongé et disposé dans le résonateur (10) dans la direction de l'intensité de champ magnétique à haute fréquence (Hx), et ce en un emplacement (20) d'intensité de champ à haute fréquence magnétique maximale et électrique minimale (Hx, Ey), **en ce que** l'échantillon de produit alimentaire, contenu dans le récipient à échantillons (22), présente des dimensions minimales dans une direction d'intensité de champ électrique à haute fréquence (Ey) croissante, et **en ce que** les échantillons sont mesurés dans un récipient à échantillons (22) qui est pourvu d'une multiplicité de compartiments à échantillons allongés avec des dimensions radiales minimales.

9. Procédé selon la revendication 8, **caractérisé en ce que** les compartiments à échantillons sont disposés parallèlement, et **en ce que** l'échantillon est introduit à une extrémité des compartiments à échantillons et est évacué à une extrémité opposée des compartiments à échantillons.

10. Procédé selon la revendication 8, **caractérisé en ce que** les compartiments à échantillons sont disposés en rangée, et **en ce que** l'échantillon est introduit à l'extrémité ouverte du premier compartiment à échantillons de la rangée, et est évacué à l'extrémité ouverte du dernier compartiment à échantillons de la rangée.

11. Procédé selon une ou plusieurs des revendications 1 à 10, **caractérisé en ce que** le produit alimentaire liquide est de la bière.

12. Dispositif d'analyse de la durée de conservation de produits alimentaires liquides par résonance de spin électronique (ESR), dans lequel un échantillon du produit alimentaire est soumis à une température supérieure à la température ambiante pendant une durée assez longue, un signal ESR de l'échantillon étant mesuré pendant cette durée, à intervalles de temps (ΔT) déterminés, l'intensité (I) du signal ESR étant portée en fonction du temps (t) et l'instant (t₀₁, t₀₂, t₀₃) d'une croissance surproportionnelle de l'intensité (I) étant enregistré, **caractérisé en ce que** pour l'analyse automatisée et intercalée en temps d'un nombre n prédéterminé d'échantillons de produits alimentaires différents au moyen d'un appareil de commande (46), il est prévu un récipient à échantillons (22) commun aux échantillons, et le dispositif comprend :
a) des moyens pour introduire un premier échantillon d'un premier produit alimentaire dans le récipient à échantillons (22) ;
b) des moyens d'analyse du premier échantillon par ESR et d'enregistrement de l'intensité (I) du signal ESR ;
c) des moyens de report de l'intensité (I) enregistrée au cours de l'étape b) comme premier point de mesure (P₁₁) dans un premier diagramme (75/1) ;
d) des moyens pour l'évacuation du premier échantillon ;
e) des moyens pour la n-1^{ième} répétition des étapes a) à d) avec les n-1 échantillons des autres produits alimentaires, au cours de l'étape c) les intensités enregistrées pour chaque produit alimentaire étant reportées comme premiers points (P₂₁ à Pₙ₁) dans un diagramme (75/2 à 75/n) séparé, et le nombre n étant tel que la n-1^{ième} répétition des étapes a) à d) coïncide sensiblement avec l'intervalle de temps (ΔT) prédéterminé ;
f) des moyens pour introduire un autre premier échantillon du premier produit alimentaire dans le récipient à échantillons (22) ;
g) des moyens d'analyse de l'autre premier échantillon par ESR et d'enregistrement de l'intensité (I) du signal ESR ;
h) des moyens de report de l'intensité (I) enregistrée à l'étape g) comme deuxième point de mesure (P₁₂) dans le premier diagramme (75/1) ;
i) des moyens pour évacuer l'autre premier échantillon ;
j) des moyens pour la n-1^{ième} répétition des étapes e) à i) avec les n-1 échantillons des autres produits alimentaires, à l'étape h), les intensités enregistrées pour chaque produit alimentaire étant reportées comme deuxièmes points (P₂₂ à Pₙ₂) dans les diagrammes (75/2 à 75/n) séparés ; et
k) des moyens pour la répétition des étapes e) à j) pour des troisièmes et autres points de mesure jusqu'à un nombre m prédéterminé de points de mesure par diagramme (75).

13. Dispositif selon la revendication 12, **caractérisé en ce que** l'échantillon est pourvu au préalable d'une substance spin-trap.

14. Dispositif selon la revendication 12, **caractérisé en ce que** l'échantillon est pourvu au préalable d'une substance spin-label.

15. Dispositif selon la revendication 12, **caractérisé en ce qu'**on utilise un échantillon avec une substance spin-trap ou spin-label présente de manière intrinsèque.

16. Dispositif selon une ou plusieurs des revendications 12 à 1 5, **caractérisé par** des moyens qui au cours des étapes d) et i) remettent en circulation les échantillons après évacuation, de manière que tous les échantillons d'un produit alimentaire déterminé soient représentés par le même échantillon.

17. Dispositif selon une ou plusieurs des revendications 12 à 15, **caractérisé par** des moyens qui au cours des étapes d) et i) éliminent les échantillons après évacuation, de manière que les échantillons d'un produit alimentaire déterminé soient prélevés en tant qu'échantillons différents d'une réserve du produit alimentaire déterminé.

18. Dispositif selon une ou plusieurs des revendications 12 à 17, **caractérisé par** un résonateur (10) dans lequel un champ électromagnétique (H, E) est susceptible de se propager, le récipient à échantillons (22) étant allongé et disposé dans le résonateur (10) dans la direction de l'intensité de champ magnétique à haute fréquence (Hx), et ce en un emplacement (20) d'intensité de champ à haute fréquence magnétique maximale et électrique minimale (Hx, Ey), en ce que l'échantillon de produit alimentaire, contenu dans le récipient à échantillons (22), présente des dimensions minimales dans une direction d'intensité de champ électrique à haute fréquence (Ey) croissante, et en ce que les échantillons sont reçus dans un récipient à échantillons (22) qui est pourvu d'une multiplicité de compartiments à échantillons allongés avec des dimensions radiales minimales.

19. Dispositif selon une ou plusieurs des revendications 12 à 18, **caractérisé en ce que** le récipient à échantillons (22a) comprend un bloc (30) qui est pourvu d'une multiplicité de perçages (32) à axes parallèles.

20. Dispositif selon la revendication 19, **caractérisé en ce que** le bloc (30, 30', 30") est sensiblement cylindrique.

21. Dispositif selon la revendication 19, **caractérisé en ce que** le bloc (30''') est sensiblement plat.

22. Dispositif selon une ou plusieurs des revendications 12 à 18, **caractérisé en ce que** le récipient à échantillons (22b) comprend un faisceau de capillaires.

23. Dispositif selon une ou plusieurs des revendications 12 à 22, **caractérisé en ce que** le rapport de la somme des surfaces radiales de la section transversale des compartiments à échantillons à la surface totale de la section transversale du récipient à échantillons (22) est compris entre 0,2 et 0,6.

24. Dispositif selon une ou plusieurs des revendications 12 à 23, **caractérisé en ce que** les compartiments à échantillons sont sensiblement cylindriques.

25. Dispositif selon la revendication 24, **caractérisé en ce que** pour une fréquence du champ électromagnétique (H, E) d'environ 10 GHz (bande X) le diamètre des compartiments à échantillons est compris entre 0,3 et 1,0 mm, de préférence entre 0,5 et 0,8 mm.

26. Dispositif selon la revendication 25, **caractérisé en ce que** pour un récipient à échantillons (22) sensiblement cylindrique son diamètre extérieur est compris entre 2,5 et 5 mm, de préférence entre 2,8 et 3,8 mm.

27. Dispositif selon la revendication 26, **caractérisé en ce que** sept ou dix-neuf compartiments à échantillons sont prévus en un paquet hexagonal très serré dans le récipient à échantillons (22).

28. Dispositif selon une ou plusieurs des revendications 12 à 27, **caractérisé en ce que** des moyens de lavage des compartiments à échantillons sont associés au récipient à échantillons (22).

29. Dispositif selon une ou plusieurs des revendications 18 à 28, **caractérisé en ce que** les compartiments à échantillons sont disposés parallèlement de manière que l'échantillon puisse être introduit à une extrémité des compartiments à échantillons et évacué à une extrémité opposée des compartiments à échantillons.

30. Dispositif selon une ou plusieurs des revendications 18 à 28, **caractérisé en ce que** les compartiments à échantillons sont disposés en rangée, et **en ce que** l'échantillon peut être introduit à l'extrémité ouverte du premier compartiment à échantillons de la rangée, et évacué à l'extrémité ouverte du dernier compartiment à échantillons de la rangée.

31. Dispositif selon la revendication 29 ou 30, **caractérisé en ce qu'**une pompe (68) est raccordée à l'extrémité d'évacuation des compartiments à échantillons.

32. Dispositif selon la revendication 31, **caractérisé en ce que** la pompe (68) est une pompe péristaltique.

33. Dispositif selon une ou plusieurs des revendications 29 à 32, **caractérisé en ce qu'**à l'extrémité d'introduction des compartiments à échantillons est raccordée une sortie (49) d'un échantillonneur (50), et **en ce que** des entrées (54/1 à 54/n) de l'échantillonneur (50) sont reliées à une pluralité de conteneurs (58/1 à 58/n) qui sont remplis de produits alimentaires différents.

34. Dispositif selon la revendication 33, **caractérisé en ce qu'**une autre entrée (60) de l'échantillonneur (50) est raccordée à un conteneur (64) qui peut être rempli d'un liquide de lavage.
